# EUROPEAN PATENT APPLICATION

(11) **EP 4 745 469 A1**
(43) Date of publication of application: **20.05.2026**
(21) Application number: 24865672.0
(22) Date of filing: 25.07.2024
(51) Int. Cl.: F24F 1/24, F24F 1/38, F24F 1/56, F24F 11/36, H05K 7/20

(54) **OUTDOOR UNIT OF AIR CONDITIONER AND AIR CONDITIONER HAVING SAME**

(30) Priority: 15.09.2023 KR 20230123499
(71) Applicant: Samsung Electronics Co., Ltd., Suwon-si, Gyeonggi-do 16677 (KR)
(72) Inventor: KIM, Hyeongju, Suwon-si Gyeonggi-do 16677 (KR); ROH, Yukyoung, Suwon-si Gyeonggi-do 16677 (KR); SUN, Woong, Suwon-si Gyeonggi-do 16677 (KR); YU, Jungho, Suwon-si Gyeonggi-do 16677 (KR); YUK, Chungwan, Suwon-si Gyeonggi-do 16677 (KR); YUN, Seungjin, Suwon-si Gyeonggi-do 16677 (KR)
(74) Representative: Walaski, Jan Filip
(86) International application number: PCT/KR2024/010827
(87) International publication number: WO 2025/058229

(57) **Abstract**

This air conditioner comprises an indoor unit and an outdoor unit. The outdoor unit comprises an outdoor unit housing, and a partition wall partitioning the inside of the outdoor unit housing into a first space and a second space. Also, the outdoor unit comprises a control box arranged in the first space, a fan which is arranged in the second space and discharges air to the outside of the outdoor unit housing, and a duct connecting the control box and the partition wall. The partition wall comprises a partition wall hole which allows the first space and the second space to be in communication with each other, the control box comprises a box hole which allows the first space and the inside of the control box to be in communication with each other, and the duct is provided to allow the partition wall hole and the box hole to be in communication with each other.

## Description

### [Technical Field]

The disclosure relates to an outdoor unit of an air conditioner including a control box, and an air conditioner including the same.

### [Background Art]

An air conditioner may refer to a device that uses a refrigeration cycle to control temperature, humidity, airflow, and distribution air to be appropriate for human activities. Components that form the refrigeration cycle include a compressor, a condenser, an evaporator, and a blower fan.

The air conditioner may be classified into a separate type in which an indoor unit and an outdoor unit are separately installed, and an integrated type in which both the indoor unit and the outdoor unit are installed in a single cabinet.

An outdoor unit of the separate type air conditioner may include a machine room in which a compressor configured to compress refrigerant and an expansion valve unit configured to decompress the refrigerant are placed. The machine room may include a refrigerant pipe connected to the compressor or the expansion valve unit so as to allow the refrigerant to flows.

The outdoor unit of the separate type air conditioner may include a control box accommodating a printed circuit board assembly for controlling the air conditioner.

### [Disclosure]

### [Technical Problem]

Embodiments of the disclosure provide an outdoor unit of an air conditioner including an improved structure to enhance safety when using a flammable refrigerant, and an air conditioner including the same.

Embodiments of the disclosure provide an outdoor unit of an air conditioner including an improved structure to reduce risk of explosion when a flammable refrigerant leaks, and an air conditioner including the same.

Embodiments of the disclosure provide an outdoor unit of an air conditioner capable of discharging a leaked flammable refrigerant to an outside, and an air conditioner including the same.

Embodiments of the disclosure provide an outdoor unit of an air conditioner including an improved structure to effectively discharge heat generated in a control box, and an air conditioner including the same.

Additional aspects of the disclosure will be set forth in part in the description which follows and, in part, will be apparent from the description, or may be learned by practice of the disclosure.

### [Technical Solution]

According to an example embodiment, the present disclosure provides an outdoor unit of an air conditioner including an outdoor unit housing. The outdoor unit of the air conditioner includes a partition wall partitioning an inside of the outdoor unit housing into a first space and a second space. The outdoor unit of the air conditioner includes a control box disposed in the first space. The outdoor unit of the air conditioner includes a fan disposed in the second space and configured to discharge air to an outside of the outdoor unit housing. The outdoor unit of the air conditioner includes a duct connecting the control box and the partition wall. The partition wall includes a partition wall hole configured to allow the first space and the second space to communicate with each other. The control box includes a box hole configured to allow the first space and an inside of the control box to communicate with each other. The duct is configured to allow the partition wall hole and the box hole to communicate with each other.

According to an example embodiment, the present disclosure provides an air conditioner including an indoor unit. The air conditioner includes an outdoor unit configured to be connected to the indoor unit. The outdoor unit includes an outdoor unit housing. The outdoor unit includes a partition wall partitioning an inside of the outdoor unit housing into a first space and a second space. The outdoor unit includes a control box disposed in the first space. The outdoor unit includes a duct disposed in the first space to connect the control box and the partition wall. The outdoor unit includes a fan disposed in the second space and configured to discharge air to an outside of the outdoor unit housing. The partition wall includes a partition wall hole configured to allow the first space and the second space to communicate with each other. The control box includes a box hole configured to communicate with an inside of the control box. The duct is configured to connect the partition wall hole and the box hole.

According to an example embodiment, the present disclosure provides an outdoor unit of an air conditioner including an outdoor unit housing. The outdoor unit of the air conditioner includes a partition wall partitioning an inside of the outdoor unit housing into a first space and a second space. The outdoor unit of the air conditioner includes a control box disposed in the first space. The outdoor unit of the air conditioner includes a fan disposed in the second space and configured to discharge air to an outside of the outdoor unit housing. The outdoor unit of the air conditioner includes a duct disposed between the control box and the partition wall. The outdoor unit housing includes a front cover disposed to cover a front side of the outdoor unit housing to which air discharged from the fan is directed. The partition wall includes a partition hole configured to allow the first space and the second space to communicate with each other. The control box includes a box hole configured to allow the first space and an inside of the control box to communicate with each other. The front cover includes an exhaust hole configured to allow the first space and an outside of the outdoor unit to communicate with each other. The duct allows the partition wall hole and the box hole to communicate with each other to allow the inside of the control box and the second space to communicate with each other.

### [Description of Drawings]

FIG. 1 is a view illustrating an air conditioner according to one embodiment.
FIG. 2 is a view illustrating an outdoor unit of the air conditioner according to one embodiment.
FIG. 3 is an exploded view of the outdoor unit of the air conditioner according to one embodiment.
FIG. 4 is a view illustrating some components of the outdoor unit of the air conditioner according to one embodiment.
FIG. 5 is an enlarged view illustrating a state in which a partition wall and a duct of FIG. 4 are coupled.
FIG. 6 is an exploded view illustrating the duct and the control box of FIG. 4.
FIG. 7 is a view illustrating FIG. 6 from a different angle.
FIG. 8 is a view illustrating a duct of an outdoor unit of an air conditioner according to one embodiment.
FIG. 9 is a view illustrating the duct of FIG. 8 from a different angle.
FIG. 10 is a cross-sectional view taken along line a-a' of FIG. 4.
FIG. 11 is a cross-sectional view taken along line b-b' of FIG. 4.

### [Modes of the Invention]

Various embodiments of the disclosure and terms used herein are not intended to limit the technical features described herein to specific embodiments, and should be understood to include various modifications, equivalents, or substitutions of the corresponding embodiments.

In describing of the drawings, similar reference numerals may be used for similar or related elements.

The singular form of a noun corresponding to an item may include one or more of the items unless clearly indicated otherwise in a related context.

In the disclosure, phrases, such as "A or B", "at least one of A and B", "at least one of A or B", "A, B or C", "at least one of A, B and C", and "at least one of A, B, or C" may include any one or all possible combinations of the items listed together in the corresponding phrase among the phrases.

As used herein, the term "and/or" includes any and all combinations of one or more of the associated listed items.

Terms such as "1st", "2nd", "primary", or "secondary" may be used simply to distinguish an element from other elements, without limiting the element in other aspects (e.g., importance or order).

When an element (e.g., a first element) is referred to as being "(functionally or communicatively) coupled" or "connected" to another element (e.g., a second element), the first element may be connected to the second element, directly (e.g., wired), wirelessly, or through a third element.

It will be understood that when the terms "includes", "comprises", "including", and/or "comprising" are used in the disclosure, they specify the presence of the specified features, figures, steps, operations, components, members, or combinations thereof, but do not preclude the presence or addition of one or more other features, figures, steps, operations, components, members, or combinations thereof.

When a given element is referred to as being "connected to", "coupled to", "supported by" or "in contact with" another element, it is to be understood that it may be directly or indirectly connected to, coupled to, supported by, or in contact with the other element. When a given element is indirectly connected to, coupled to, supported by, or in contact with another element, it is to be understood that it may be connected to, coupled to, supported by, or in contact with the other element through a third element.

It will also be understood that when an element is referred to as being "on" another element, it may be directly on the other element or intervening elements may also be present.

An air conditioner according to various embodiments may refer to a device that performs functions such as purification, ventilation, humidity control, cooling or heating in an air conditioning space (hereinafter referred to as "indoor space"), and in particular a device having at least one of these functions.

According to an embodiment, an air conditioner may include a heat pump device to perform a cooling function or a heating function. The heat pump device may include a refrigeration cycle in which a refrigerant is circulated through a compressor, a first heat exchanger, and an expansion device and a second heat exchanger. Components of the heat pump device may be embedded in a single housing forming an exterior of an air conditioner, which includes a window-type air conditioner or a portable air conditioner. On the other hand, some components of the heat pump device may be divided and embedded in a plurality of housings forming a single air conditioner, which includes a wall-mounted air conditioner, a stand-type air conditioner, and a system air conditioner.

The air conditioner including the plurality of housings may include at least one outdoor unit installed outdoors and at least one indoor unit installed indoors. For example, the air conditioner may be provided such that a single outdoor unit and a single indoor unit are connected by a refrigerant pipe. The air conditioner may be provided such that a single outdoor unit is connected to two or more indoor units by a refrigerant pipe. The air conditioner may be provided such that two or more outdoor units and two or more indoor units are connected by a plurality of refrigerant pipes.

The outdoor unit may be electrically connected to the indoor unit. For example, information (or commands) for controlling the air conditioner may be received through an input interface provided in the outdoor unit or the indoor unit. The outdoor unit and the indoor unit may operate simultaneously or sequentially in response to a user input.

The air conditioner may include an outdoor heat exchanger provided in the outdoor unit, an indoor heat exchanger provided in the indoor unit, and a refrigerant pipe connecting the outdoor heat exchanger and the indoor heat exchanger.

The outdoor heat exchanger may be configured to exchange heat between a refrigerant and air from outdoor through a phase change of the refrigerant (e.g., evaporation or condensation). For example, while the refrigerant is condensed in the outdoor heat exchanger, the refrigerant may radiate heat to the outdoor air. While the refrigerant flowing in the outdoor heat exchanger evaporates, the refrigerant may absorb heat from the outdoor air.

The indoor unit is installed indoors. For example, according to the arrangement method of the indoor unit, the air conditioner may be classified into a ceiling-type indoor unit, a stand-type indoor unit, a wall-type indoor unit, and the like. For example, the ceiling-type indoor unit may be classified into a 4-way type indoor unit, a 1-way type indoor unit, a duct type indoor unit and the like according to a method of discharging air.

The indoor heat exchanger may be configured to exchange heat between a refrigerant and outdoor air through a phase change of the refrigerant (e.g., evaporation or condensation). For example, while the refrigerant evaporates in the indoor unit, the refrigerant may absorb heat from the indoor air. The indoor space may be cooled by blowing the indoor air cooled through the cooled indoor heat exchanger. While the refrigerant is condensed in the indoor heat exchanger, the refrigerant may radiate heat to the indoor air. The indoor space may be heated by blowing the indoor air heated through the high-temperature indoor heat exchanger.

In other words, the air conditioner may perform a cooling or heating function by a phase change process of a refrigerant circulated between the outdoor heat exchanger and the indoor heat exchanger. To circulate the refrigerant, the air conditioner may include a compressor to compress the refrigerant. The compressor may draw refrigerant gas through an inlet and compress the refrigerant gas. The compressor may discharge high-temperature and high-pressure refrigerant gas through an outlet. The compressor may be disposed inside the outdoor unit.

Through the refrigerant pipe, the refrigerant may be circulated sequentially through the compressor, the outdoor heat exchanger, the expansion device, and the indoor heat exchanger or sequentially circulated through the compressor, the indoor heat exchanger, the expansion device, and the outdoor heat exchanger.

For example, in the air conditioner, when a single outdoor unit and a single indoor unit are directly connected through a refrigerant pipe, the refrigerant may be circulated between the single outdoor unit and the single indoor unit through the refrigerant pipe.

For example, in the air conditioner, when a single outdoor unit is connected to two or more indoor units through a refrigerant pipe, the refrigerant may flow from the single outdoor unit to the plurality of indoor units through branched refrigerant pipes. Refrigerant discharged from the plurality of indoor units may be combined and circulated to the outdoor unit. For example, each of the plurality of indoor units may be directly connected in parallel to the single outdoor unit through a separate refrigerant pipe.

Each of the plurality of indoor units may be operated independently according to an operation mode set by a user. In other words, some of the plurality of indoor units may be operated in a cooling mode while others of the plurality of indoor units are operated in a heating mode. At that time, the refrigerant may be selectively introduced into each indoor unit in a high-pressure state or a low-pressure state, discharged, and circulated to the outdoor unit along a circulation path that is designated through a flow path switching valve to be described in greater detail below.

For example, in the air conditioner, when two or more outdoor units and two or more indoor units are connected by the plurality of refrigerant pipes, refrigerant discharged from the plurality of outdoor units may be combined and flow through one refrigerant pipe, and then diverged again at a certain point and introduced into the plurality of indoor units.

All of the plurality of outdoor units may be driven or at least some of the plurality of outdoor units may not be driven, in accordance with to a driving load corresponding to an operating amount of the plurality of indoor units. At that time, the refrigerant may be provided through a flow path switching valve to be introduced into and circulated to an outdoor unit that is selectively driven. The air conditioner may include the expansion device to reduce the pressure of the refrigerant flowing into the heat exchanger. For example, the expansion device may be disposed inside the indoor unit or inside the outdoor unit, or disposed both inside the indoor unit and the outdoor unit.

The expansion device may reduce the temperature and pressure of the refrigerant using a throttling effect. The expansion device may include an orifice configured to reduce a cross-sectional area of a flow path. A temperature and pressure of the refrigerant passing through the orifice may be lowered.

For example, the expansion device may be implemented as an electronic expansion valve configured to adjust an opening ratio (a ratio of a cross-sectional area of a flow path of a valve in a partially opened state to a cross-sectional area of the flow path of the valve in a fully opened state). According to the opening ratio of the electronic expansion valve, the amount of refrigerant passing through the expansion device may be adjusted.

The air conditioner may further include a flow path switching valve disposed on the refrigerant circulation path. The flow path switching valve may include a 4-way valve. The flow path switching valve may determine a refrigerant circulation path depending on an operation mode of the indoor unit (e.g., cooling operation or heating operation). The flow path switching valve may be connected to the outlet of the compressor.

The air conditioner may include an accumulator. The accumulator may be connected to the inlet of the compressor. A low-temperature and low-pressure refrigerant, which is evaporated in the indoor heat exchanger or the outdoor heat exchanger, may flow into the accumulator.

When a refrigerant mixture of refrigerant liquid and refrigerant gas is introduced, the accumulator may separate the refrigerant liquid from the refrigerant gas, and supply the refrigerant gas separated from the refrigerant liquid to the compressor.

An outdoor fan may be installed near the outdoor heat exchanger. The outdoor fan may blow outdoor air to the outdoor heat exchanger to promote heat exchange between the refrigerant and the outdoor air.

The outdoor unit of the air conditioner may include at least one sensor. For example, the outdoor unit sensor may be provided as an environmental sensor. The outdoor unit sensor may be disposed at a given position of the inside or the outside of the outdoor unit. For example, the outdoor unit sensor may include a temperature sensor configured to detect an air temperature around the outdoor unit, an air humidity sensor configured to detect air humidity around the outdoor unit, or a refrigerant temperature sensor configured to detect a refrigerant temperature in a refrigerant pipe passing through the outdoor unit, or a refrigerant pressure sensor configured to detect a refrigerant pressure in a refrigerant pipe passing through the outdoor unit.

The outdoor unit of the air conditioner may include outdoor unit communication circuitry. The outdoor unit communication circuitry may be configured to receive a control signal from an indoor unit controller of the air conditioner, which will be described in greater detail below. Based on a control signal received through the outdoor unit communication circuitry, the outdoor unit may control the operation of the compressor, the outdoor heat exchanger, the expansion device, the flow path switching valve, the accumulator, or the outdoor fan. The outdoor unit may transmit a measurement value detected by the outdoor unit sensor to the indoor unit controller through the outdoor unit communication circuitry.

The indoor unit of the air conditioner may include a housing, a blower configured to circulate air inside or outside the housing, and the indoor heat exchanger configured to exchange heat with air introduced into the housing.

The housing may include an inlet. Indoor air may flow into the housing through the inlet.

The indoor unit of the air conditioner may include a filter configured to filter out foreign substance in air that is introduced into the inside of the housing through the inlet.

The housing may include an outlet. Air flowing inside the housing may be discharged to the outside of the housing through the outlet.

An airflow guide configured to guide a direction of air discharged through the outlet may be provided in the housing of the indoor unit. For example, the airflow guide may include a blade positioned in the outlet. For example, the airflow guide may include an auxiliary fan for regulating an exhaust airflow, but is not limited thereto. Alternatively, the airflow guide may be omitted.

The indoor heat exchanger and the blower arranged on a flow path connecting the inlet and the outlet may be disposed inside the housing of the indoor unit.

The blower may include an indoor fan and a fan motor. For example, the indoor fan may include an axial fan, a mixed-flow fan, a cross-flow fan and a centrifugal fan.

The indoor heat exchanger may be arranged between the blower and the outlet or between the inlet and the blower. The indoor heat exchanger may absorb heat from air introduced through the inlet or transfer heat to air introduced through the inlet. The indoor heat exchanger may include a heat exchange tube through which refrigerant flows, and heat exchange fins in contact with the heat exchange tube to increase a heat transfer area.

The indoor unit of the air conditioner may include a drain tray disposed below the indoor heat exchanger to collect condensed water generated in the indoor heat exchanger. The condensed water contained in the drain tray may be drained to the outside through a drain hose. The drain tray may be arranged to support the indoor heat exchanger.

The indoor unit of the air conditioner may include an input interface. The input interface may include any type of user input means including a button, a switch, a touch screen and/or a touch pad. A user can directly input setting data (e.g., desired indoor temperature, cooling/ heating/ dehumidifying/air cleaning operation mode setting, outlet selection setting, and /or air volume setting) through the input interface.

The input interface may be connected to an external input device. For example, the input interface may be electrically connected to a wired remote controller. The wired remote controller may be installed at a specific location (e.g., a part of a wall) in an indoor space. A user may input setting data related to the operation of the air conditioner by manipulating the wired remote controller. An electrical signal corresponding to the setting data obtained by the wired remote controller may be transmitted to the input interface. In addition, the input interface may include an infrared sensor. A user may remotely input the setting data for operating the air conditioner using a wireless remote controller. The setting data received by the wireless remote controller may be transmitted to the input interface as an infrared signal.

The input interface may include a microphone. A user's voice command may be obtained through the microphone. The microphone may convert a user's voice command into an electrical signal and transmit the converted electrical signal to the indoor unit controller. The indoor unit controller may control components of the air conditioner to perform a function corresponding to the user's voice command. The setting data obtained through the input interface (e.g., desired indoor temperature, cooling/ heating/ dehumidifying/air cleaning operation mode setting, outlet selection setting, and /or air volume setting) may be transmitted to the indoor unit controller to be described in greater detail below. For example, the setting data obtained through the input interface may be transmitted to the outside, that is, to the outdoor unit or a server through an indoor unit communication circuitry to be described in greater detail below.

The indoor unit of the air conditioner may include a power module. The power module may be connected to an external power source to supply power to components of the indoor unit.

The indoor unit of the air conditioner may include an indoor unit sensor. The indoor unit sensor may be an environmental sensor disposed inside or outside the housing. For example, the indoor unit sensor may include one or more temperature sensors and/or humidity sensors disposed in a predetermined space inside or outside the housing of the indoor unit. For example, the indoor unit sensor may include a refrigerant temperature sensor configured to detect a refrigerant temperature of a refrigerant pipe passing through the indoor unit. For example, the indoor unit sensor may include a refrigerant temperature sensor each configured to detect a temperature of an entrance, a middle portion and/or an exit of the refrigerant pipe passing through the indoor heat exchanger.

For example, each environmental information detected by the indoor unit sensor may be transmitted to the indoor unit controller to be described in greater detail below or transmitted to the outside through the indoor unit communication circuitry to be described in greater detail below.

The indoor unit of the air conditioner may include indoor unit communication circuitry. The indoor unit communication circuitry may include at least one of a short-range wireless communication module and a long-range wireless communication module. The indoor unit communication circuitry may include at least one antenna for wirelessly communicating with other devices. The outdoor unit may include the outdoor unit communication circuitry. The outdoor unit communication circuitry may also include at least one of a short-range wireless communication module and a long-range wireless communication module.

The short-range wireless communication module may include a Bluetooth communication module, a Bluetooth Low Energy (BLE) communication module, a near field communication module, a WLAN (Wi-Fi) communication module, and a Zigbee communication module, an infrared data association (IrDA) communication module, a Wi-Fi Direct (WFD) communication module, an ultrawideband (UWB) communication module, an Ant+ communication module, a microwave (uWave) communication module, etc., but is not limited thereto.

The long-range wireless communication module may include a communication module that performs various types of long-range wireless communication, and may include a mobile communication circuitry. The mobile communication circuitry transmits and receives radio signals with at least one of a base station, an external terminal, and a server in a mobile communication network.

The indoor unit communication circuitry may communicate with an external device such as a server, a mobile device and other home appliances through an access point (AP). The AP may connect a local area network (LAN), to which an air conditioner or a user device is connected, to a wide area network (WAN) to which a server is connected. The air conditioner or the user device may be connected to the server through the WAN. The indoor unit of the air conditioner may include the indoor unit controller configured to control components of the indoor unit including the blower. The outdoor unit of the air conditioner may include an outdoor unit controller configured to control components of the outdoor unit including the compressor. The indoor unit controller may communicate with the outdoor unit controller through the indoor unit communication circuitry and the outdoor unit communication circuitry. The outdoor unit communication circuitry may transmit a control signal generated by the outdoor unit controller to the indoor unit communication circuitry, or transmit a control signal, which is transmitted from the indoor unit communication circuitry, to the outdoor unit controller. In other words, the outdoor unit and the indoor unit may perform bi-directional communication. The outdoor unit and the indoor unit may transmit and receive various signals generated during the operation of the air conditioner.

The outdoor unit controller may be electrically connected to components of the outdoor unit and may control the operation of each component. For example, the outdoor unit controller may adjust a frequency of the compressor and control the flow path switching valve to change a circulation direction of the refrigerant. The outdoor unit controller may adjust a rotational speed of the outdoor fan. In addition, the outdoor unit controller may generate a control signal to adjust the opening degree of the expansion valve. Under the control of the outdoor unit controller, the refrigerant may be circulated along the refrigerant circulation circuit including the compressor, the flow path switching valve, the outdoor heat exchanger, the expansion valve, and the indoor heat exchanger.

Various temperature sensors included in the outdoor unit and the indoor unit may transmit electrical signals corresponding to detected temperatures to the outdoor unit controller and/or the indoor unit controller. For example, the humidity sensors included in the outdoor unit and the indoor unit may respectively transmit electrical signals corresponding to the detected humidity to the outdoor unit controller and/or the indoor unit controller.

The indoor unit controller may obtain a user input from a user device including a mobile device through the indoor unit communication circuitry, or directly obtain a user input through the input interface or the remote controller. The indoor unit controller may control components of the indoor unit including the blower in response to the received user input. The indoor unit controller may transmit information related to the received user input to the outdoor unit controller of the outdoor unit.

The outdoor unit controller may control components of the outdoor unit including the compressor based on the information related to the user input received from the indoor unit. For example, when a control signal corresponding to a user input for selecting an operation mode such as a cooling operation, a heating operation, a fan operation, a defrosting operation, or a dehumidifying operation is received from the indoor unit, the outdoor unit controller may control components of the outdoor unit to perform an operation of the air conditioner corresponding to the selected operation mode.

The outdoor unit controller and the indoor unit controller may include a processor and a memory, respectively. The indoor unit controller may include at least one a first processor and at least one a first memory, and the outdoor unit controller may include at least one a second processor and at least one a second memory.

The memory may record/store various types of information necessary for the operation of the air conditioner. The memory may store instructions, applications, data and/or programs necessary for the operation of the air conditioner. For example, the memory may store various programs for the cooling operation, the heating operation, the dehumidifying operation, and /or the defrosting operation of the air conditioner. The memory may include volatile memory, such as a static random access memory (S-RAM) and a dynamic random access memory (D-RAM) for temporarily storing data. In addition, the memory may include a non-volatile memory, such as a read only memory (ROM), an erasable programmable read only memory (EPROM), and an electrically erasable programmable read only memory (EEPROM) for long-term storage of data.

The processor may generate a control signal for controlling an operation of the air conditioner based on instructions, applications, data, and/or programs stored in the memory. The processor may be hardware and may include a logic circuit and an arithmetic circuit. The processor may process data according to a program and/or instructions provided from the memory, and may generate a control signal according to a processing result. The memory and the processor may be implemented as one control circuit or as a plurality of circuits.

The indoor unit of the air conditioner may include an output interface. The output interface may be electrically connected to the indoor unit controller, and output information related to the operation of the air conditioner under the control of the indoor unit controller. For example, the output interface may output information, such as an operation mode selected by a user input, a wind direction, a wind volume, and a temperature. In addition, the output interface may output sensing information obtained from the indoor unit sensor or the outdoor unit sensor, and output warning /error messages.

The output interface may include a display and a speaker. The speaker may be a sound device and configured to output various sounds. The display may display information, which is input by a user or provided to a user, as various graphic elements. For example, operational information of the air conditioner may be displayed as at least one of an image and text. In addition, the display may include an indicator that provides specific information. The display may include a liquid crystal display (LCD) panel, a light emitting diode (LED) panel, an organic light emitting diode (OLED) panel, a micro-LED panel, and/or a plurality of LEDs.

Hereinafter various example embodiments of the present disclosure will be described in greater detail with reference to the accompanying drawings.

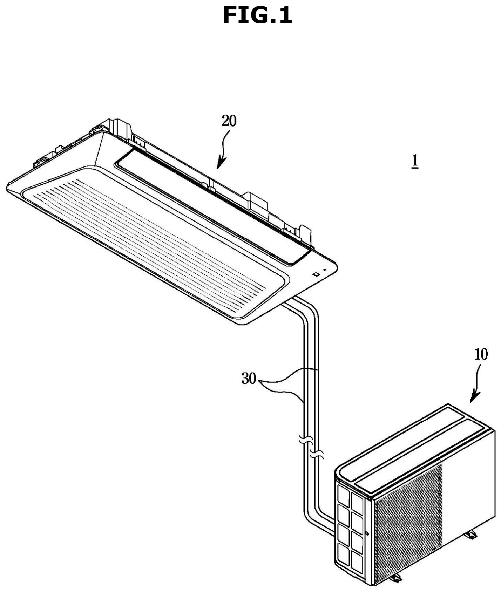

FIG. 1 is a view illustrating an air conditioner according to one embodiment.

Referring to FIG. 1, an air conditioner 1 according to an embodiment of the present disclosure may include an indoor unit 20 disposed in an indoor space and the outdoor unit 10 disposed in an outdoor space.

In order to cool an air conditioning space that is subject to air conditioning, the air conditioner 1 may absorb heat from an inside of the air conditioning space and emit heat to an outside of the air conditioning space. In order to heat the air conditioning space, the air conditioner 1 may absorb heat from the outside of the air conditioning space and emit heat to the inside of the air conditioning space.

On the outside of the air conditioning space, the outdoor unit 10 may exchange heat with outdoor air. The outdoor unit 10 may perform heat exchange between a refrigerant and outdoor air using a phase change of the refrigerant. For example, the outdoor unit 10 may emit heat from the refrigerant to the outdoor air using the condensation of the refrigerant. Further, the outdoor unit 10 may absorb heat from outdoor air into the refrigerant using the evaporation of the refrigerant.

FIG. 1 illustrates a single outdoor unit 10, but the number of outdoor units 10 is not limited to that shown in FIG. 1. For example, the air conditioner 1 may include a plurality of outdoor units 10.

The outdoor unit 10 may include an outdoor heat exchanger 11 configured to exchange heat with outdoor air, and a compressor 12 configured to compress refrigerant gas.

A configuration of the outdoor unit 10 will be described in greater detail below.

The indoor unit 20 may exchange heat with indoor air within the air conditioning space. The indoor unit 20 may perform heat exchange between the refrigerant and indoor air using a phase change of the refrigerant. For example, the indoor unit 20 may cool the air conditioning space by absorbing heat from indoor air into the refrigerant using the evaporation of the refrigerant. Further, the indoor unit 20 may heat the air conditioning space by discharging heat from the refrigerant to the indoor air using the condensation of the refrigerant.

The indoor unit 20 may include an indoor heat exchanger configured to exchange heat with indoor air, an indoor blower fan configured to draw and blow indoor air to allow the indoor air to pass through the indoor heat exchanger, and an expansion valve unit configured to decompress and expand the refrigerant.

FIG.1 illustrates a single indoor unit 20, but the number of indoor units 20 is not limited to that shown in FIG. 1. For example, the air conditioner 1 may include a plurality of indoor units 20. A plurality of different indoor units may be respectively installed in a plurality of different air conditioning spaces.

FIG. 1 illustrates that the indoor unit 20 is a ceiling type-one-way indoor unit in which air is discharged in one direction, but this is merely an example. The indoor unit 20 may include a ceiling-type indoor unit, a stand-type indoor unit, a wall-mounted indoor unit, and the like. It should be understood that the ceiling-type indoor unit includes a duct-type indoor unit and a four-way indoor unit in which air is discharged in all directions.

As mentioned above, the air conditioner 1 may perform the heat exchange between the refrigerant and outdoor air on the outside of the air conditioning space, and perform the heat exchange between the refrigerant and indoor air within the air conditioning space.

The air conditioner 1 may include a connection pipe 30 provided to transfer the refrigerant between the indoor unit 20 and the outdoor unit 10 in order to move heat between the outside of the air conditioning space and the inside of the air conditioning space. The connection pipe 30 may move the refrigerant between the outside of the air conditioning space and the inside of the air conditioning space. The outdoor unit 10 may be provided to be connected to the indoor unit 20. Particularly, the indoor unit 20 and the outdoor unit 10 may be connected to each other through the connection pipe 30 provided to transfer the refrigerant. The type of the refrigerant may include a flammable refrigerant and a non-flammable refrigerant. In addition, the type of refrigerant may include a refrigerant having physical properties heavier than air and a refrigerant having physical properties lighter than air.

The above-mentioned air conditioner 1 is merely an example of the air conditioner to which the outdoor unit of the air conditioner according to the present disclosure is applied, but the present disclosure is not limited thereto. The configuration of the air conditioner 1 to which the outdoor unit 10 of the air conditioner according to the present disclosure is applied, the indoor unit 20 included therein, the connection pipe 30, and the like may vary.

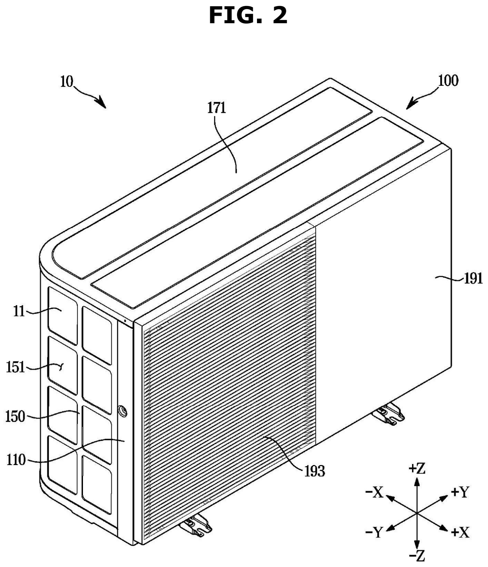

Hereinafter the outdoor unit of the air conditioner according to one embodiment of the present disclosure will be described in greater detail with reference to FIGS. 2 to 11.

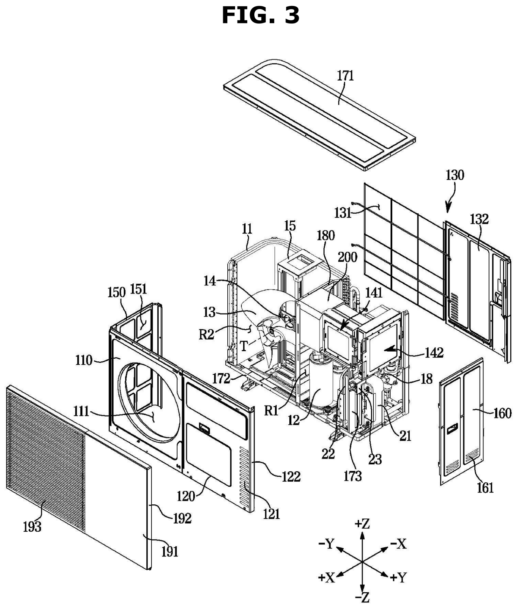

FIG. 2 is a view illustrating an outdoor unit of the air conditioner according to one embodiment. FIG. 3 is an exploded view of the outdoor unit of the air conditioner according to one embodiment.

Referring to FIGS. 2 and 3, the outdoor unit 10 of the air conditioner according to an embodiment of the present disclosure may include the outdoor heat exchanger 11 configured to exchange heat with outdoor air, the compressor 12 configured to compress a refrigerant, a fan 13 configured to draw in outdoor air into an inside of an outdoor unit housing 100 and configured to discharge the air back to an outside of the outdoor unit housing 100 to allow the outdoor air to pass through the outdoor heat exchanger 11, and the outdoor unit housing 100 forming an exterior of the outdoor unit 10.

The outdoor unit housing 100 may form the exterior of the outdoor unit 10. Various components of the outdoor unit 10, such as the outdoor heat exchanger 11, the compressor 12, the fan 13, the refrigerant pipe 18 and control boxes 141 and 142 described in greater detail below, may be received inside the outdoor unit housing 100.

The outdoor unit housing 100 may include an air inlet 131 formed to allow air to flow in and a fan air outlet 111 formed to allow air to flow out. As the fan 13 rotates, air outside the outdoor unit housing 100 may flow in through the air inlet 131, and after exchanging heat with the outdoor heat exchanger 11, the air may be discharged to the outside of the outdoor unit housing 100 through the fan air outlet 111.

The outdoor unit 10 may include a partition wall 180. The partition wall 180 may extend upward (+Z direction) from a base 172 (described in greater detail below).

The partition wall 180 may partition the inside of the outdoor unit housing 100 into a first space R1 and a second space R2. For example, the first space R1 and the second space R2 may be arranged in the left and right direction (+-Y direction) in the drawing, and the partition wall 180 may be arranged to extend in the up and down direction (+-Z direction) in the drawing and partition the inside of the outdoor unit housing 100.

For example, the outdoor unit 10 may include the first space R1 formed inside the outdoor unit housing 100. Components such as the compressor 12 and the control boxes 141 and 142 to be described in greater detail below may be placed in the first space R1.

The outdoor unit 10 may include the second space R2 formed inside the outdoor unit housing 100. Heat exchange of the refrigerant may occur in the second space R2.

Outside air may be introduced into the second space R2, and the introduced air may be discharged back to the outside. In the second space R2, heat exchange may be performed between the outdoor heat exchanger 11 and the air introduced from the outside. Components such as the outdoor heat exchanger 11, the fan 13, and the like may be arranged in the second space R2.

For example, the outdoor unit housing 100 may be formed to have a substantially box shape.

Hereinafter an example of the structure of the outdoor unit housing 100 will be described in greater detail.

The outdoor unit housing 100 may include a first front cover 120. The first front cover 120 may cover a front side (+X direction) of the first space R1. For example, the first front cover 120 may be provided to cover a front side of the outdoor unit 10.

The first front cover 120 may be provided to cover a portion of the first space R1 that is open in a direction parallel to a direction in which a rotation axis T of the fan 13 extends.

The outdoor unit housing 100 may include a second front cover 110. The second front cover 110 may cover a front side of the second space R2. The fan air outlet 111 may be formed in the second front cover 110.

For example, the first front cover 120 may be formed in a substantially flat plate shape. For convenience of description, the first front cover 120 may be referred to and described as a "front cover 120" in the following. Accordingly, the outdoor unit housing 100 may be described and expressed as including the front cover 120 that is provided to cover the front side of the outdoor unit 10.

The front cover 120 may include a front exhaust hole 121. The front exhaust hole 121 may allow the first space R1 to communicate with the outside of the outdoor unit 10 so as to allow the refrigerant leaked into the first space R1 to be discharged to the outside of the outdoor unit 10 when a refrigerant leaks from the refrigerant pipe 18 accommodated in the outdoor unit housing 100. That is, the front exhaust hole 121 may be formed to penetrate the front cover 120.

A plurality of front exhaust holes 121 may be provided. For example, the front cover 120 may include the plurality of front exhaust holes 121. The plurality of front exhaust holes 121 may be arranged in the up and down direction on one surface of the front cover 120. In the drawing, it is illustrated that the plurality of front exhaust holes 121 is located on the lateral side (+Y side) of the front cover 120, but this is only an example. Alternatively, the plurality of front exhaust holes 121 may be formed in various locations of the front cover 120 to allow the first space R1 to communicate with the outside.

The leaked refrigerant may have physical properties heavier than air. Therefore, the leaked refrigerant may accumulate in a lower side of a space in which the refrigerant pipe 18 is arranged. Because the plurality of front exhaust holes 121 arranged in the up and down direction is formed on one surface of the front cover 120, the leaked refrigerant accumulated in the first space R1 where the refrigerant pipe 18 is arranged may be exhausted to the outside through the plurality of front exhaust holes 121.

The front cover 120 may include a front cover extension 122. The front cover extension 122 may be formed to cover a portion of a lateral side of the outdoor unit 10 when the front cover 120 covers the front side of the outdoor unit 10.

For example, the second front cover 110 and the front cover 120 (the first front cover) may be arranged side by side in the left and right direction. The second front cover 110 and the front cover 120 (the first front cover) may be coupled to each other.

The outdoor unit housing may include a rear frame 130. The rear frame 130 may be provided to cover the rear side (-X direction) of the outdoor unit housing.

The rear frame 130 may include a first rear frame 133. The first rear frame 133 may form a portion of a rear exterior of the outdoor unit 10. The first rear frame 133 may be positioned at a rear side of the second space R2. The air inlet 131 may be formed in the first rear frame 133.

The first rear frame 133 may be arranged to allow one surface thereof to face the second front cover 110.

The rear frame 130 may include a second rear frame 132. The second rear frame 132 may form another portion of the rear exterior of the outdoor unit 10. The second rear frame 132 may cover the rear side of the first space R1.

The second rear frame 132 may be arranged to allow one surface thereof to face the front cover 120.

The outdoor unit housing 100 may include a first lateral cover 160. The first lateral cover 160 may form one surface of the outdoor unit 10 in the right direction (+Y direction). That is, the first lateral cover 160 may be provided to cover the lateral side of the outdoor unit 10. For example, the first lateral cover 160 may be formed in a substantially flat plate shape.

The outdoor unit housing 100 may include a second lateral cover 150. The second lateral cover 150 may form one surface of the outdoor unit 10 in the left direction (-Y direction).

The second lateral cover 150 may cover the second space R2. The second lateral cover 150 may cover the second space R2 from the left side. A lateral side air inlet 151 may be formed in the second lateral cover 150.

The second lateral cover 150 may be coupled to the second front cover 110. The second lateral cover 150 may be connected to the first rear frame 133.

For example, the second lateral cover 150 may be arranged to extend in the front and rear direction (+-X direction).

Hereinafter for the convenience of description, the first lateral cover 160 may be referred to and described as a 'lateral cover 160'. Accordingly, the lateral cover 160 may be expressed and described as forming one surface of the outdoor unit housing 100 in the right direction (+Y direction) of the outdoor unit 10.

The lateral cover 160 may be coupled to the front cover 120. The lateral cover 160 may be coupled to the second rear frame 132.

For example, the lateral cover 160 may be arranged to extend in the front and rear direction (+-X direction).

The lateral cover 160 may be arranged to allow one surface thereof to face the second lateral cover 150.

For example, the lateral cover 160 may include a plurality of lateral exhaust holes 121 provided to allow the first space R1 to communicate with the outside of the outdoor unit 10. Through the plurality of lateral exhaust holes 121, air within the first space R1 may flow from the first space R1 to the outside.

The plurality of lateral exhaust holes 121 may be arranged in the front and rear direction (+-X direction) on one surface of the lateral cover 160.

The plurality of lateral exhaust holes 21 may be located on the lower side of the lateral cover 160. When a refrigerant leaks from the refrigerant pipe 18, the leaked refrigerant may flow into the first space R1. The leaked refrigerant may have a physical property that is heavier than air depending on the type. Therefore, the leaked refrigerant may accumulate on the lower side of the space where the refrigerant pipe 18 is arranged. At this time, because the plurality of lateral exhaust holes 121 is formed on the lower side of the lateral cover 160, the leaked refrigerant accumulated on the lower side of the space where the refrigerant pipe 18 is arranged may be exhausted to the outside through the plurality of lateral exhaust holes 121.

The outdoor unit housing 100 may include the base 172. The base 172 may form a lower surface of the outdoor unit 10. The base 172 may be arranged on one lower side of the first space R1 and the second space R2. The base 172 may support various components of the outdoor unit 10 accommodated inside the outdoor unit housing 100 from the lower side.

The base 172 may be coupled to a lower portion of each of the first front cover 120, the second front cover 110, the second rear frame 132, the first lateral cover 160, and the second lateral cover 150.

The base 172 may be formed to have a substantially flat plate shape.

The outdoor unit housing 100 may include a top cover 171. The top cover 171 may form an upper surface of the outdoor unit 10.

The top cover 171 may cover upper portions of the first space R1 and the second space R2. The top cover 171 may cover various components of the outdoor unit 10 accommodated inside the outdoor unit housing 100 from the upper side.

The top cover 171 may be coupled to the upper portion of each of the first front cover 120, the second front cover 110, the second rear frame 132, the first lateral cover 160, and the second lateral cover 150.

The top cover 171 may be formed to have a substantially flat plate shape.

The top cover 171 may be positioned to allow one surface thereof to face the base 172.

The outdoor unit housing 100 may include an outlet grille 193. The outlet grille 193 may cover the front side of the second front cover 110. The outlet grille 193 may cover the front side of the fan air outlet 111. The outlet grille 193 may be coupled to the second front cover 110. The outlet grille 193 may form a portion of the front (+X direction) exterior of the outdoor unit 10.

The outlet grille 193 may be formed to include the shape of a grille to allow air to be discharged from the fan air outlet 111 while covering the fan air outlet 111.

The outdoor unit housing 100 may include an outer cover 191. The outer cover 191 may cover the front cover 120 from the front side. The outer cover 191 may be coupled to the front cover 120.

The outer cover 191 may form other portion of the front (+X direction) exterior of the outdoor unit 10.

For example, the outlet grille 193 and the outer cover 191 may be arranged side by side in the left and right direction (+-Y direction). The outlet grille 193 and the outer cover 191 may be coupled to each other.

Components included in the outdoor unit housing 100 may be provided to be detachable from each other. For example, the front cover 120 may be provided to be detachable from the second front cover 110, the lateral cover 160, the top cover 171, the base 172, and the like.

For example, the lateral cover 160 may be provided to be detachable from the front cover 120, the second rear frame 132, the top cover 171, the base 172, and the like.

For example, the top cover 171 may be provided to be detachable from the first front cover 120, the second front cover 110, the second rear frame 132, the first lateral cover 160, and the second lateral cover 150.

Accordingly, when it is necessary to perform work such as inspecting, replacing, or repairing components within the outdoor unit 10, a worker can perform the work by separating at least one component of the outdoor unit housing 100.

The configuration of the outdoor unit housing 100 included in the air conditioner 1 according to the present disclosure is not limited to that described above.

The outdoor heat exchanger 11 may be configured to exchange heat with outdoor air. The outdoor heat exchanger 11 may be configured to allow a refrigerant to flow therein. Heat exchange between the refrigerant and outdoor air may occur in the outdoor heat exchanger 11.

For example, during a cooling operation of the air conditioner 1, high-pressure and high-temperature refrigerant gas may be condensed in the outdoor heat exchanger 11, and while the refrigerant is condensed, the refrigerant may release heat to the outdoor air. During the cooling operation of the air conditioner 1, the outdoor heat exchanger 11 may discharge a refrigerant liquid.

During a heating operation of the air conditioner 1, a low-temperature and low-pressure refrigerant liquid may evaporate in the outdoor heat exchanger 11, and while the refrigerant evaporates, the refrigerant may absorb heat from the outdoor air. During the heating operation of the air conditioner 1, the outdoor heat exchanger 11 may discharge the refrigerant gas.

The outdoor heat exchanger 11 may be disposed to face the air inlet 131 in the second space R2.

The compressor 12 may compress refrigerant gas and discharge high-temperature and high-pressure refrigerant gas. For example, the compressor 12 may include a motor and a compression mechanism, and the compression mechanism may compress refrigerant gas by a torque of the motor.

The outdoor unit 10 of the air conditioner may include the refrigerant pipe 18. The refrigerant pipe 18 may be arranged inside the outdoor unit housing 100. The refrigerant pipe 18 may be connected to various devices in the first space R1 through which the refrigerant flows, thereby allowing the refrigerant to flow.

The outdoor unit 10 may include the control boxes 141 and 142. The outdoor unit 10 may include a plurality of printed circuit boards (not shown) for controlling the operation of various components of the outdoor unit 10. Various electronic components may be mounted on the plurality of printed circuit boards. The plurality of printed circuit boards may be accommodated in the control boxes 141 and 142. The control boxes 141 and 142 may be disposed in the first space R1.

The printed circuit board provided in the control boxes 141 and 142 may be electrically connected to various components of the outdoor unit 10, such as the compressor 12, a fan motor 14, a plate heat exchanger 21, and an expansion tank 22. With the configuration, the printed circuit board may be configured to control the operation of various components of the outdoor unit 10. The printed circuit board may be provided to receive detection signals from various sensors provided in the compressor 12, the outdoor heat exchanger 11, and the like.

The outdoor unit 10 may include a cable guide 23. The cable guide 23 may have a role of supporting and guiding a cable connected to the printed circuit board of the control boxes 141 and 142.

The outdoor unit 10 may include a duct 200. The duct 200 may be provided to connect the control boxes 141 and 142 and the partition wall 180. A detailed description of the duct 200 will be described in greater detail below.

The outdoor unit 10 may include the fan 13 configured to move air and the fan motor 14 configured to generate a rotational force for the fan 13 to rotate.

For example, the outdoor unit 10 may include a motor bracket 15 provided to support the fan 13 and the fan motor 14. The motor bracket 15 may be disposed in the second space R2.

For example, the outdoor unit 10 may include the plate heat exchanger 21. The plate heat exchanger 21 may be configured to exchange heat between a refrigerant and water. The plate heat exchanger 21 may be arranged inside the outdoor unit housing 100. For example, the plate heat exchanger 21 may be arranged in the first space R1.

For example, the outdoor unit 10 may include a water pipe that is provided to allow water to flow in or discharge from the outside. The water pipe may be connected to the plate heat exchanger 21. At least a portion of the water pipe may be arranged inside the outdoor unit housing 100. For example, at least a portion of the water pipe may be arranged in the first space R1.

Water that is introduced into the outdoor unit 10 from the outside through the water pipe may exchange heat with a high-temperature refrigerant inside the plate heat exchanger 21. Inside the plate heat exchanger 21, water may absorb heat from the high-temperature refrigerant and transfer the heat back to the outside of the outdoor unit 10 through the water pipe.

For example, the outdoor unit 10 may include the expansion tank 22. When a water temperature rises due to the plate heat exchanger 21, a volume inside the water pipe may increase, and the expansion tank 22 may be provided to prevent a sudden increase in a water pressure caused by the increased volume. The expansion tank 22 may be arranged inside the outdoor unit housing 100. For example, the expansion tank 22 may be arranged in the first space R1.

As mentioned above, the outdoor unit 10 according to an embodiment may form a portion of a heating system that supplies hot water, including the plate heat exchanger 21, the water pipe, and the expansion tank 22.

However, the present disclosure is not limited thereto, and in the air conditioner 1 according to an embodiment, the plate heat exchanger 21, the water pipe, and the expansion tank 22 may be provided outside the outdoor unit 10. The air conditioner 1 according to an embodiment may not be equipped with a heating system.

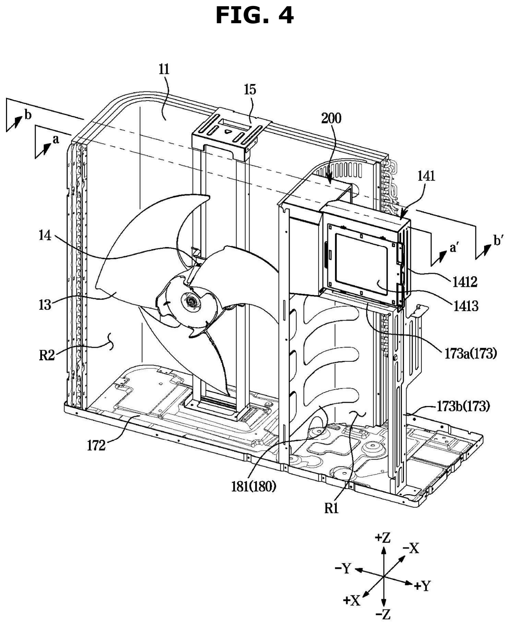

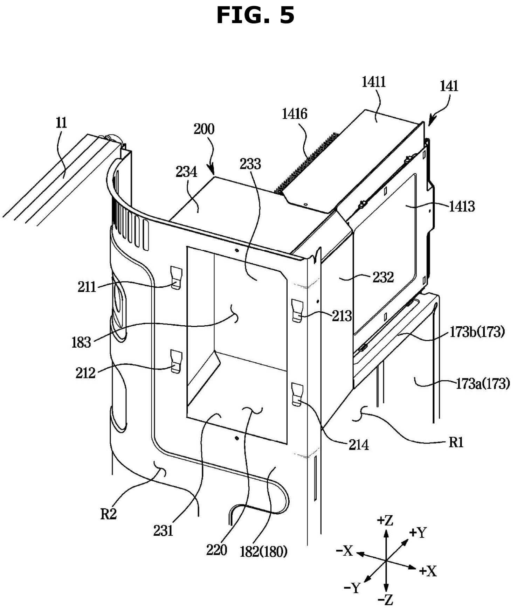

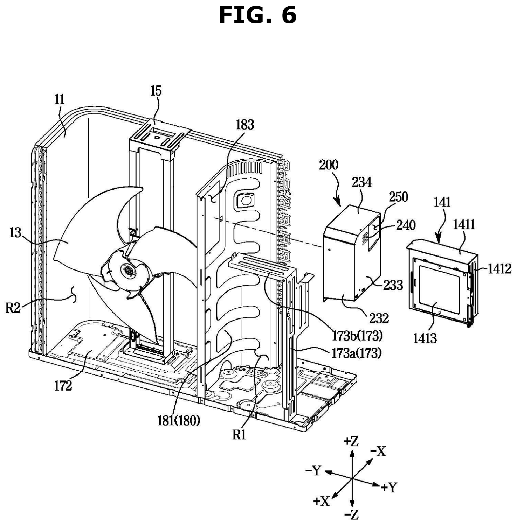

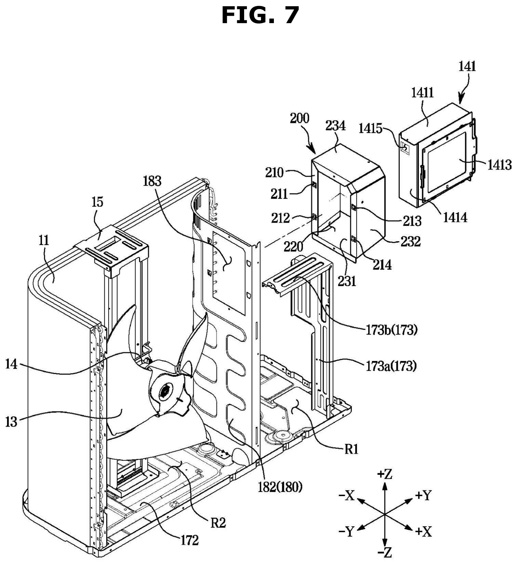

FIG. 4 is a view illustrating some components of the outdoor unit of the air conditioner according to one embodiment. FIG. 5 is an enlarged view illustrating a state in which a partition wall and a duct of FIG. 4 are coupled. FIG. 6 is an exploded view illustrating the duct and the control box of FIG. 4. FIG. 7 is a view illustrating FIG. 6 from a different angle.

Referring to FIGS. 4 to 7, the partition wall 180 may include a partition wall hole 183 provided to allow the first space R1 and the second space R2 to communicate with each other. The partition wall hole 183 may be formed on the upper side of the partition wall 180. The partition wall hole 183 may be formed to penetrate the partition wall 180. Although it is illustrated that the partition wall hole 183 has a substantially rectangular shape, this is merely an example. The shape and size of the partition wall hole 183 may be provided in various ways.

The partition wall 180 may include a first partition wall surface 181 arranged to face the first space R1. The partition wall 180 may include a second partition wall surface 182 arranged to face the second space R2.

The outdoor unit 10 may include a support 173 provided to support the control box 141. The support 173 may be coupled to the base 172 and disposed in the first space R1.

The support 173 may include a first support portion 173a extending upward from the base 172. The first support portion 173a may be positioned to be spaced apart from the partition wall 180. The first support portion 173a may be coupled to the base 172.

The support 173 may include a second support portion 173b extending from the first support portion 173a toward the second partition wall surface 182 in a direction parallel to the base 172.

The first support portion 173a may be extended to approximately a height at which the partition wall hole 183 is formed. The control box 141 may be positioned on the upper side of the first space R1 by the first support portion 173a. The control box 141 may be positioned within the first space R1 by being seated to the second support portion 173b. Because the support 173 allows the control box 141 to be positioned on the upper side of the first space R1, even when a refrigerant flows into the first space R1, a phenomenon of refrigerant flowing into the control box 141 may be prevented.

The control box 141 may include a box hole 1415. The box hole 1415 may allow the first space R1 and the inside of the control box 141 to communicate with each other.

The box hole 1415 may be formed on one surface 1414 of the control box 141 arranged to face the second space R2. The box hole 1415 may be formed on an upper side of the one surface 1414 of the control box 141. Because the box hole 1415 is formed on the upper side of the one surface 1414 of the control box 141, even when a leaked refrigerant flows into the first space R1, a phenomenon of the refrigerant flowing into the inside of the control box 141 may be prevented.

The plurality of exhaust holes 121 arranged on the front cover 120 may be arranged to be positioned lower than the box hole 1415. Accordingly, the refrigerant leaking into the first space R1 may be discharged to the outside by the plurality of exhaust holes 121 before the refrigerant accumulates at the position of the box hole 1415.

The control box 141 may include a box cover 1413. The box cover 1413, in which the printed circuit board is arranged, may be coupled to the inside of the control box 141 and thus the control box 141 may accommodate the printed circuit board.

The control box 141 may include a heat sink 1416. Heat generated from the printed circuit board inside the control box 141 may be discharged to the first space R1 through the heat sink 1416. Heat generated from the printed circuit board may be discharged to the outside of the control box 141 through the box hole 1415. A detailed description thereof will be provided in greater detail below.

The outdoor unit 10 may include the duct 200. The duct 200 may be disposed between the control box 141 and the partition wall 180. The duct 200 may connect the control box 141 and the partition wall 180 to each other.

The duct 200 may be formed to extend in the left and right direction (+-Y direction) in the drawing to connect the control box 141 and the partition wall 180. Depending on the type of outdoor unit 10, a distance between the partition wall 180 and the control box 141 may vary, and the duct 200 may be manufactured to extend to various lengths to connect the control box 141 and the partition wall 180.

The duct 200 may be coupled to the partition wall 180. For example, coupling members 211, 212, 213, and 214 may be formed on an edge portion 210 (described in greater detail below) of the duct 200 arranged to face the second space R2.

The coupling members 211, 212, 213, and 214 may be mountable on the partition wall 180 so as to couple the duct 200 to the partition wall 180. The coupling members 211, 212, 213, and 214 may be formed along the edge portion 210. Although it is illustrated that four coupling members 211, 212, 213, and 214 are provided, this is merely an example. Alternatively, the number of the coupling members may vary for coupling the partition wall 180 to the duct 200.

The duct 200 may include a first opening 220 connected to the partition wall hole 183. The first opening 220 may be provided to allow the outside and the inside of the duct 200 to communicate with each other. A size of the first opening 220 may be formed to correspond to a size of the partition wall hole 183.

For example, the first opening 220 may be formed on the one surface 210 of the duct 200 arranged to face the second space R2. The duct 200 may be coupled to the partition wall 180 to allow the partition wall hole 183 and the first opening 220 to correspond to each other.

The duct 200 may include the edge portion 210 formed along an outer circumference of the first opening 220. The duct 200 may be arranged to allow the edge portion 210 to face the second space R2. When the duct 200 is coupled to the partition wall 180, the edge portion 210 may be arranged to be in close contact with the partition wall 180. In other words, when the duct 200 is coupled to the partition wall 180, the edge portion 210 may be arranged to be in close contact with the second partition wall surface 182 of the partition wall 180.

Accordingly, it is possible to prevent a phenomenon in which the refrigerant, which is leaked to the first space R1, flows into the duct 200 through the first opening 220.

The duct 200 may include a duct lateral portion 232 extending in the left and right direction (+-Y direction) from the edge portion 210 and a duct upper surface portion 234. The duct lateral portion 232 and the duct upper surface portion 234 may extend to a position, in which the control box 141 is disposed, to allow the control box 141 and the duct 200 to be coupled to each other.

The duct 200 may include a second opening 240 connected to the box hole 1415. The second opening 240 may be formed on one surface 233 of the duct 200 facing in a direction opposite to the direction toward the second space R2. In other words, the one surface 233 of the duct 200 may be provided to face the edge portion 210. The one surface 233 of the duct 200 may also be described as one surface 233 of the duct 200 adjacent to the second opening 240.

The duct 200 may be coupled to the control box 141. When the duct 200 is coupled to the control box 141, the second opening 240 may be provided to communicate with the box hole 1415. In other words, the inside of the control box 141 may communicate with the inside of the duct 200 through the box hole 1415 and the second opening 240. A size of the second opening 240 may be formed to correspond to a size of the box hole 1415.

When the duct 200 is coupled to the control box 141, the one surface 233 of the duct 200 in which the second opening 240 is formed may be arranged to be in close contact with the one surface 1414 of the control box 141 in which the box hole 1415 is formed. Accordingly, it is possible to prevent the refrigerant, which is leaked into the first space R1, from flowing into the inside of the duct 200 and the control box 141 through the second opening 240 and the box hole 1415.

Because the first opening 220 of the duct 200 communicates with the partition wall hole 183 of the partition wall 180 and the second opening 240 communicates with the box hole 1415 of the control box 141, the duct 200 may allow the partition wall hole 183 and the box hole 1415 to communicate with each other.

The partition wall hole 183 is provided to communicate with the second space R2, and the box hole 1415 is provided to communicate with the inside of the control box 141. Accordingly, the duct 200 may allow the inside of the control box 141 to communicate with the second space R2.

When the fan 13 disposed in the second space R2 operates to exhaust air to the outside of the outdoor unit housing 100, a pressure in the second space R2 may be lowered compared to the pressure in an internal space of the duct 200 and the control box 141. Accordingly, the air inside the control box 141 may flow to the second space R2 through the duct 200 and ultimately be exhausted to the outside of the outdoor unit housing 100.

Accordingly, the leaked refrigerant, which flows into the inside of the control box 141, may be smoothly discharged from the inside of the control box 141 to the outside of the outdoor unit housing 100. In addition, the heat generated from the printed circuit board may be smoothly discharged from the inside of the control box 141 to the outside of the outdoor unit housing 100. Therefore, the safety of use of the outdoor unit 10 may be further improved.

The size of the first opening 220 may be formed larger than the size of the second opening 240. For example, the size of the partition wall hole 183 may also be formed larger than the size of the box hole 1415. Therefore, when the fan 13 operates and air flows from the inside of the control box 141 to the second space R2, a speed of the air flowing in the box hole 1415 may be greater than a speed of the air flowing in the partition wall hole 183 due to Bernoulli's Principle. Because a speed of the air flowing from the box hole 1415 to the outside is relatively fast, the refrigerant inside the control box 141 may be discharged more effectively.

The duct 200 may include a third opening 250 provided to allow the first space R1 and the inside of the duct 200 to communicate with each other. The third opening 250 may be formed on the one surface 233 of the duct 200 facing in a direction opposite to the direction toward the first space R1. The third opening 250 may be arranged on a lateral surface of the second opening 240.

The third opening 250 may be positioned rearward (-X direction) of the second opening 240. The third opening 250 may have a substantially rectangular shape, but is not limited thereto and may be formed in various shapes.

By the third opening 250, the first space R1 may communicate with the second space R2 through the duct 200. When a refrigerant leaks, the refrigerant leaked into the first space R1 may flow into the duct 200 through the third opening 250, flow into the second space R2 and be discharged to the outside of the outdoor unit housing 100.

When the fan 13 operates, the pressure in the second space R2 may become lower than the pressure inside the duct 200 and the first space R1. Therefore, the internal air of the first space R1 may be introduced into the third opening, flow into the second space R2 through the duct 200, and be discharged to the outside of the outdoor unit housing 100 by the fan 13.

Accordingly, the refrigerant leaked inside the first space R1 may be discharged from the first space R1 to the outside of the outdoor unit housing 100. The heat discharged to the first space R1 through the heat sink 1416 of the control box 141 may also be discharged to the outside of the outdoor unit housing 100 through the above process.

The third opening 250 may be formed at the upper end of the duct 200. In other words, the third opening 250 may be formed at an upper end of one surface of the duct 200.

Even when the fan 13 does not operate, the leaked refrigerant flowing into the first space R1 may be prevented from flowing into the inside of the duct 200 because the third opening 250 is formed at the upper end of the duct 200. Accordingly, it is possible to prevent a phenomenon in which the leaked refrigerant, which flows into the third opening 250 when the fan 13 does not operate, flows into the box hole 1415 through the duct 200.

A size of the third opening 250 may be formed smaller than the size of the partition wall hole 183. Therefore, when the fan 13 operates and air flows from the first space R1 to the second space R2, a speed of the air flowing in the third opening 250 may be greater than a speed of the air flowing in the partition wall hole 183 due to Bernoulli's principle. Because a speed of the air flowing from the first space R1 into the duct 200 is relatively fast, the leaked refrigerant settled in the first space R1 may be discharged more effectively.

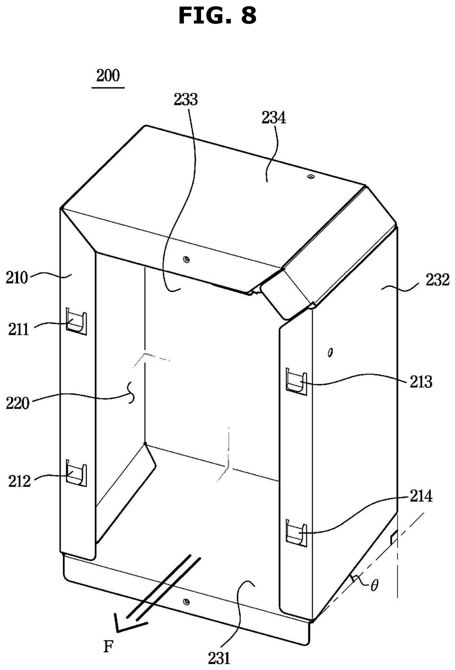

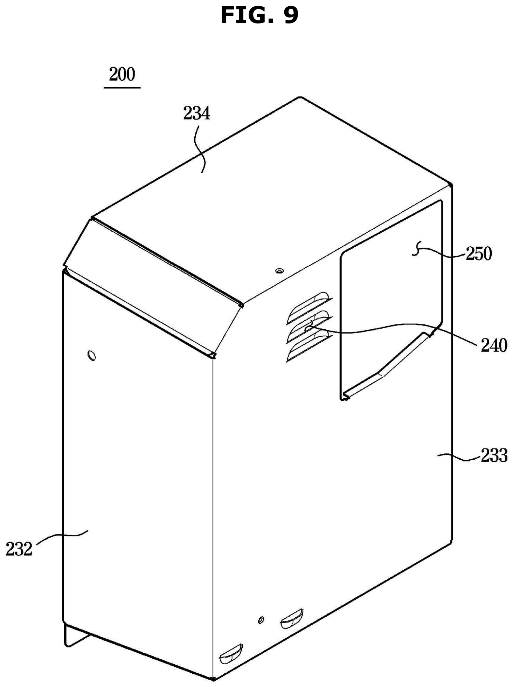

FIG. 8 is a view illustrating a duct of an outdoor unit of an air conditioner according to one embodiment. FIG. 9 is a view illustrating the duct of FIG. 8 from a different angle.

Referring to FIGS. 8 and 9, the duct 200 may include a lower surface 231 formed on the lower side of the duct 200. The lower surface 231 may be formed to be inclined downward in a direction from the first space R1 toward the second space R2. In other words, the lower surface 231 may be formed to allow a portion facing the first space R1 to be higher than a portion facing the second space R2.

When air moves in the duct 200 by the fan 13, heat exchange may occur in the outdoor unit 10, and thus water vapor may be liquefied by the temperature difference. Accordingly, dew may be formed inside the duct 200. The water may flow to the lower surface 231 by gravity. The water flowing to the lower surface 231 may be discharged from the inside of the duct 200 to the first space R1 because the lower surface 231 is formed to be inclined downward from the first space R1 to the second space R2 (F). Therefore, a phenomenon, in which water accumulates inside the duct 200, may be prevented.

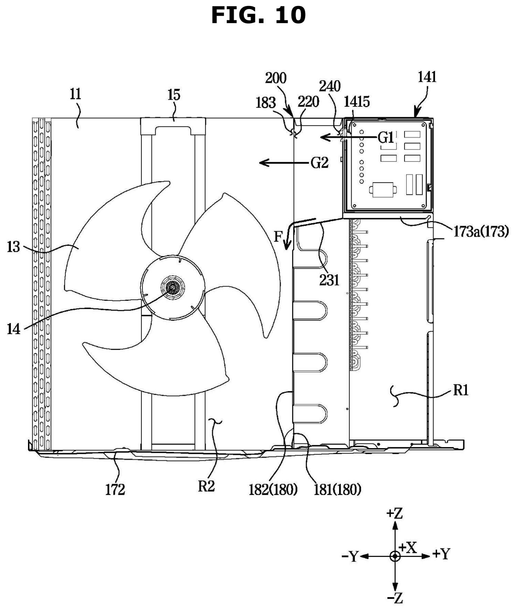

The lower surface 231 of the duct 200 may be arranged to extend to the one surface 182 of the partition wall 180 facing the second space R2 (refer to FIG. 10). Accordingly, water flowing from the lower surface 231 may be discharged more smoothly into the first space R1.

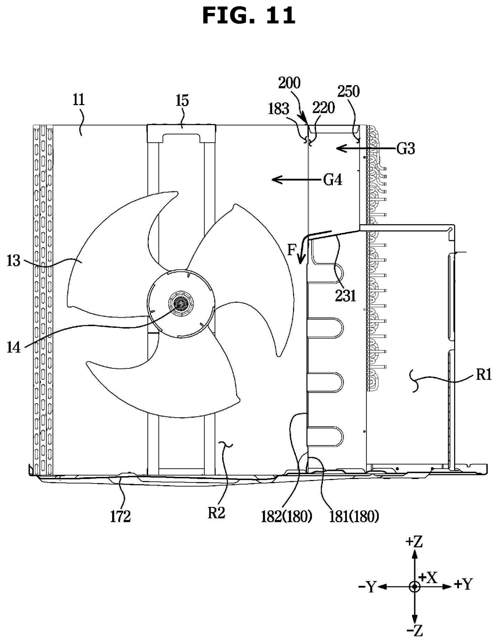

FIG. 10 is a cross-sectional view taken along line a-a' of FIG. 4. FIG. 11 is a cross-sectional view taken along line b-b' of FIG. 4.

The line of a-a' is arranged to pass through the second opening 240 and the box hole 1415 among some components of the outdoor unit 10 illustrated in FIG. 4. The line of b-b' is arranged to pass through the third opening 250 among some components of the outdoor unit 10 illustrated in FIG. 4.

Hereinafter a process, in which air flows when the fan rotates, will be described in greater detail with reference to FIGS. 10 and 11.

Referring to FIG. 10, when the fan 13 operates, a negative pressure is formed in the second space R2, and thus the air inside the control box 141 may flow into the inside of the duct 200 through the box hole 1415 and the second opening 240 (G1). The air flowing into the inside of the duct 200 may flow into the second space R2 through the first opening 220 and the partition hole 183 (G2). Thereafter, the air flowing into the second space R2 may be discharged to the outside of the outdoor unit housing 100 through the fan air outlet 111 and the outlet grille 193.

Accordingly, the leaked refrigerant or heat present inside the control box 141 may be smoothly discharged to the outside of the outdoor unit housing 100.

Referring to FIG. 11, when the fan 13 operates, a negative pressure is formed in the second space R2, and thus the air inside the first space R1 may flow into the inside of the duct 200 through the third opening 250 (G3). The air flowing into the inside of the duct may flow into the second space R2 through the first opening 220 and the partition wall hole 183 (G4). Thereafter, the air flowing into the second space R2 may be discharged to the outside of the outdoor unit housing 100 through the fan air outlet 111 and the outlet grille 193.

Accordingly, the leaked refrigerant or heat present inside the first space R1 may be smoothly discharged to the outside of the outdoor unit housing 100.

An outdoor unit 10 of an air conditioner according to an example embodiment may include an outdoor unit housing 100. The outdoor unit 10 of the air conditioner may include a partition wall 180 partitioning an inside of the outdoor unit housing 100 into a first space R1 and a second space R2. The outdoor unit 10 of the air conditioner may include a control box 141 disposed in the first space R1. The outdoor unit 10 of the air conditioner may include a fan 13 disposed in the second space R2 and configured to discharge air to an outside of the outdoor unit housing 100. The outdoor unit 10 of the air conditioner may include a duct 200 connecting the control box 141 and the partition wall 180. The partition wall 180 may include a partition wall hole 183 provided to allow the first space R1 and the second space R2 to communicate with each other. The control box 141 may include a box hole 1415 provided to allow the first space R1 and the inside of the control box 141 to communicate with each other. The duct 200 may be provided to allow the partition wall hole 183 and the box hole 1415 to communicate with each other.

In response to the operation of the fan 13, air inside the control box 141 may flow to the second space R2 through the duct 200 and be discharged to the outside of the outdoor unit housing 100.

The duct 200 may include a first opening 220 connected to the partition wall hole 183, and a second opening 240 connected to the box hole 1415. A size of the first opening 220 may be formed larger than a size of the second opening 240.

The duct 200 may further include an edge portion 210 formed along an outer circumference of the first opening 220. The duct 200 may be provided to be couplable to the partition wall 180. The edge portion 210 may be provided to be in close contact with the partition wall 180 in response to the duct 200 being coupled to the partition wall 180.

The edge portion 210 may include coupling members 211, 212, 213 and 214 mountable to the partition wall 180 to allow the duct 200 to be coupled to the partition wall 180.

The duct 200 may be provided to be couplable to the control box 141. In response to the duct 200 being coupled to the control box 141, one surface 233 of the duct 200 adjacent to the second opening 240 may be provided to be in close contact with the control box 141.

A size of the partition wall hole 183 may be formed larger than a size of the box hole 1415.

The outdoor unit housing 100 may include a cover 120 provided to cover a portion of the first space R1 that is open in a direction parallel to a direction in which a rotation axis T of the fan 13 extends. The cover 120 may include an exhaust hole 121 provided to allow the first space R1 to communicate with an outside of the outdoor unit 10 to allow a refrigerant, which is leaked to the first space R1, to be discharged to the outside of the outdoor unit 10 in response to a refrigerant being leaked from a refrigerant pipe 18 accommodated in the outdoor unit housing 100.

The exhaust hole 121 may include a plurality of exhaust holes 121 arranged in a vertical direction. The plurality of exhaust holes 121 may be positioned lower than the box hole 1415.

The box hole 1415 may be formed at an upper end of the control box 141.

A lower surface 231 of the duct 200 may be formed to be inclined downward in a direction from the first space R1 toward the second space R2.

The lower surface 231 of the duct 200 may be provided to extend to one surface of the partition wall 180 facing the second space R2.

The duct 200 may further include a third opening 250 communicating with the first space R1 to allow the first space R1 to communicate with the second space R2 through the duct 200. In response to the operation of the fan 13, air inside the first space R1 may flow to the second space R2 through the duct 200 and be discharged to the outside of the outdoor unit housing 100.

The third opening 250 may be formed at an upper end of the duct 200. A size of the third opening 250 may be formed smaller than a size of the partition wall hole 183.

The outdoor unit 10 of the air conditioner may further include a support 173 extending from a lower surface of the outdoor unit housing 100 to support the control box 141 so as to allow the control box 141 to be positioned on an upper side of the first space R1.

An air conditioner 1 according to an example embodiment may include an indoor unit 20. The air conditioner 1 may include an outdoor unit 10 provided to be connected to the indoor unit 20. The outdoor unit 10 may include an outdoor unit housing 100. The outdoor unit 10 may include a partition wall 180 partitioning an inside of the outdoor unit housing 100 into a first space R1 and a second space R2. The outdoor unit 10 may include a control box 141 disposed in the first space R1. The outdoor unit 10 may include a duct 200 disposed in the first space R1 to connect the control box 141 and the partition wall 180. The outdoor unit 10 may include a fan 13 disposed in the second space R2 and configured to discharge air to an outside of the outdoor unit housing 100. The partition wall 180 may include a partition wall hole 183 provided to allow the first space R1 and the second space R2 to communicate with each other. The control box 141 may include a box hole 1415 provided to communicate with an inside of the control box 141. The duct 200 may be provided to connect the partition wall hole 183 and the box hole 1415.

In response to the operation of the fan 13, air inside the control box 141 may flow to the second space R2 through the duct 200 and be discharged to the outside of the outdoor unit housing 100.

The outdoor unit housing 100 may include a cover 120 provided to cover a portion of the first space R1 that is open in a direction parallel to a direction in which a rotation axis T of the fan 13 extends. The cover 120 may include an exhaust hole 121 provided to allow the first space R1 to communicate with an outside of the outdoor unit 10 to allow a refrigerant, which is leaked to the first space R1, to be discharged to the outside of the outdoor unit 10 in response to a refrigerant being leaked from a refrigerant pipe 18 accommodated in the outdoor unit housing 100. The exhaust hole 121 may be positioned lower than the box hole 1415.

The duct 200 may be provided to be couplable to the partition wall 180 and the control box 141. The duct 200 may include a first opening 220 connected to the partition wall hole 183, and a second opening 240 connected to the box hole 1415, and an edge portion 210 formed along an outer circumference of the first opening 220. In response to the duct 200 being coupled to the control box 141, one surface 233 of the duct 200 adjacent to the second opening 240 may be provided to be in close contact with the control box 141.

An outdoor unit 10 of an air conditioner according to an example embodiment may include an outdoor unit housing 100. The outdoor unit 10 of the air conditioner may include a partition wall 180 partitioning an inside of the outdoor unit housing 100 into a first space R1 and a second space R2. The outdoor unit 10 of the air conditioner may include a control box 141 disposed in the first space R1. The outdoor unit 10 of the air conditioner may include a fan 13 disposed in the second space R2 and configured to discharge air to an outside of the outdoor unit housing 100. The outdoor unit 10 of the air conditioner may include a duct 200 disposed between the control box 141 and the partition wall 180. The outdoor unit housing 100 may include a front cover 120 disposed to cover a front side of the outdoor unit housing 100 to which air discharged from the fan 13 is directed. The partition wall 180 may include a partition hole 183 provided to allow the first space R1 and the second space R2 to communicate with each other. The control box 141 may include a box hole 1415 provided to allow the first space R1 and an inside of the control box 141 to communicate with each other. The front cover 120 may include an exhaust hole 121 provided to allow the first space R1 and an outside of the outdoor unit 10 to communicate with each other. The duct 200 may allow the partition wall hole 183 and the box hole 1415 to communicate with each other so as to allow the inside of the control box 141 and the second space R2 to communicate with each other.

As is apparent from the above description, a duct may be provided to allow a box hole to be partitioned from an inside of an outdoor unit housing, and thus a leaked refrigerant may be prevented from flowing into an inside of the control box, thereby improving safety.

A second opening connected to a box hole may be formed on an upper side of a duct, and thus a leaked refrigerant may be prevented from flowing into the control box through the second opening, thereby improving stability.

A leaked refrigerant may be discharged to an outside through an exhaust hole connected to a first space of an outdoor unit housing, thereby improving safety during use.

An inside of a control box may communicate with a second space, in which a fan is placed, through a duct, and thus heat generated in the control box may be effectively discharged.

Additional aspects of the disclosure will be set forth in part in the description which follows and, in part, will be obvious from the description, or may be learned by practice of the disclosure.

While the present disclosure has been particularly described with reference to exemplary embodiments, it should be understood by those of skilled in the art that various changes in form and details may be made without departing from the spirit and scope of the present disclosure.

## Claims

1. An outdoor unit of an air conditioner comprising:
an outdoor unit housing;
a partition wall partitioning an inside of the outdoor unit housing into a first space and a second space;
a control box disposed in the first space;
a fan disposed in the second space and configured to discharge air to an outside of the outdoor unit housing; and
a duct connecting the control box and the partition wall,
wherein the partition wall comprises a partition wall hole configured to allow the first space and the second space to communicate with each other; and
the control box comprises a box hole configured to allow the first space and an inside of the control box to communicate with each other,
wherein the duct is configured to allow the partition wall hole and the box hole to communicate with each other.

2. The outdoor unit of the air conditioner of claim 1, wherein
in response to the operation of the fan, air inside the control box is configured to flow to the second space through the duct and is discharged to the outside of the outdoor unit housing.

3. The outdoor unit of the air conditioner of claim 1, wherein
the duct comprises:
a first opening connected to the partition wall hole; and
a second opening connected to the box hole,
wherein a size of the first opening is larger than a size of the second opening.

4. The outdoor unit of the air conditioner of claim 3, wherein
the duct further comprises an edge portion formed along an outer circumference of the first opening,
wherein the duct is configured to be couplable to the partition wall,
wherein the edge portion is in contact with the partition wall in response to the duct being coupled to the partition wall.

5. The outdoor unit of the air conditioner of claim 4, wherein
the edge portion comprises a coupling member mountable to the partition wall to allow the duct to be coupled to the partition wall.

6. The outdoor unit of the air conditioner of claim 3, wherein
the duct is configured to be couplable to the control box,
wherein in response to the duct being coupled to the control box, one surface of the duct adjacent to the second opening is in contact with the control box.

7. The outdoor unit of the air conditioner of claim 1, wherein
a size of the partition wall hole is larger than a size of the box hole.

8. The outdoor unit of the air conditioner of claim 1, wherein
the outdoor unit housing comprises a cover configured to cover a portion of the first space open in a direction parallel to a direction in which a rotation axis of the fan extends,
wherein the cover comprises an exhaust hole configured to allow the first space to communicate with an outside of the outdoor unit to allow a refrigerant leaked to the first space to be discharged to the outside of the outdoor unit in response to a refrigerant being leaked from a refrigerant pipe accommodated in the outdoor unit housing.

9. The outdoor unit of the air conditioner of claim 8, wherein
the exhaust hole comprises a plurality of exhaust holes arranged in a vertical direction,
wherein the plurality of exhaust holes is positioned lower than the box hole.

10. The outdoor unit of the air conditioner of claim 1, wherein
the box hole is formed at an upper end of the control box.

11. The outdoor unit of the air conditioner of claim 1, wherein
a lower surface of the duct is inclined downward in a direction from the first space toward the second space.

12. The outdoor unit of the air conditioner of claim 11, wherein
the lower surface of the duct is extends to one surface of the partition wall facing the second space.

13. The outdoor unit of the air conditioner of claim 2, wherein
the duct further comprises a third opening communicating with the first space to allow the first space to communicate with the second space through the duct,
wherein in response to the operation of the fan, air inside the first space flows through the duct to the second space and is discharged to the outside of the outdoor unit housing.

14. The outdoor unit of the air conditioner of claim 13, wherein
the third opening is formed at an upper end of the duct,
wherein a size of the third opening is smaller than the size of the partition wall hole.

15. The outdoor unit of the air conditioner of claim 1, further comprising:
a support extending from a lower surface of the outdoor unit housing and configured to support the control box to allow the control box to be positioned on an upper side of the first space.
